# EUROPEAN PATENT APPLICATION

(11) **EP 2 056 360 A1**
(43) Date of publication of application: **06.05.2009**
(21) Application number: 07119492.2
(22) Date of filing: 29.10.2007
(51) Int. Cl.: H01L 31/052

(54) **Solar Cell Dissipation Package**

(71) Applicant: Atomic Energy Council - Institute of Nuclear Energy Research, Lungtan, Taoyuan, Taiwan (TW)
(72) Inventor: Hong, Hwen-Fen, 333, CHIAAN VILLAGE, LUNGTAN, TAOYUAN (TW); Lin, Kuo-Hsin, 333, CHIAAN VILLAGE, LUNGTAN, TAOYUAN (TW); Shih, Zun-Hao, 333, CHIAAN VILLAGE, LUNGTAN, TAOYUAN (TW); Shin, Hwa-Yuh, 333, CHIAAN VILLAGE, LUNGTAN, TAOYUAN (TW); Kuo, Cherng-Tsong, 333, CHIAAN VILLAGE, LUNGTAN, TAOYUAN (TW)
(74) Representative: Beck, Michael Rudolf

(57) **Abstract**

A dissipation package of a solar cell is provided. The package swiftly dissipates the heat generated by the solar cell and a circuit layer coordinated. It is done by binding a ceramic layer under the circuit layer to a dissipation unit with a buffer layer and a mount layer in between.

## Description

### Field of the invention

The present invention relates to a dissipation package; more particularly, relates to binding a ceramic layer to a dissipation unit with a buffer layer and a mount layer in between for improving dissipation efficiency.

### Description of the Related Art

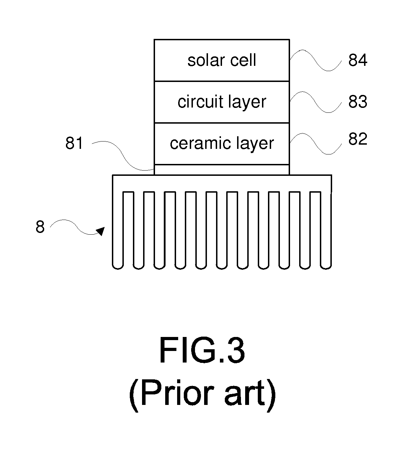

A prior art of a dissipation device for a solar cell is shown in FIG.3. The prior art comprises a fin set 8; a thermal grease 81 on the fin set 8; a ceramic layer 82 on the thermal grease 81; a circuit layer 83 on the ceramic layer 82 and a solar cell 84 on the circuit layer 83. Therein, the solar cell 84 absorbs sun light for a photo-electric conversion. Then, the solar cell 84 transfers energy obtained to a storage unit by the circuit layer 83; and a thermal radiation generated from the solar cell 84 and the circuit layer 83 is dissipated through the fin set 8.

However, because the heat generated is so great, the thermal grease 81 may be deformed and thus make the ceramic layer 82 departed from the fin set 8. As a result, the heat generated from the solar cell 84 and the circuit layer 83 is not effectively dissipated so that the functionality and stability of the solar cell 84 and the circuit layer 83 are not good on using. Hence, the prior art does not fulfill all users' requests on actual use.

### Summary of the invention

The main purpose is to bind a ceramic layer to a dissipation unit with a buffer layer and a mount layer in between for improving dissipation efficiency.

To achieve the above purpose, the present invention is a solar cell dissipation package, comprising a dissipation unit having a flat surface or further having fins on the flat surface; a mount layer mounted on the flat surface; a buffer layer mounted on the mount layer; a ceramic layer mounted on the buffer layer; a circuit layer mounted on the ceramic layer; and a solar cell mounted on the circuit layer. Accordingly, a novel solar cell dissipation package is obtained.

### Brief description of the drawings

The present invention will be better understood from the following detailed descriptions of the preferred embodiments according to the present invention, taken in conjunction with the accompanying drawings, in which
FIG.1A is the sectional view showing the first preferred embodiment according to the present invention;
FIG.1B is the sectional view showing the second preferred embodiment;
FIG.2 is the sectional view showing the state of use; and
FIG.3 is the view of the prior art.

### Descriptions of the preferred embodiments

The following descriptions of the preferred embodiments are provided to understand the features and the structures of the present invention.

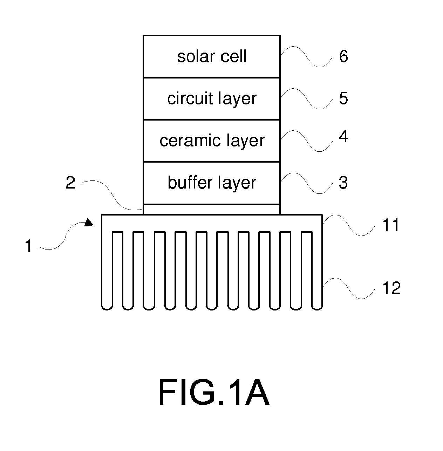

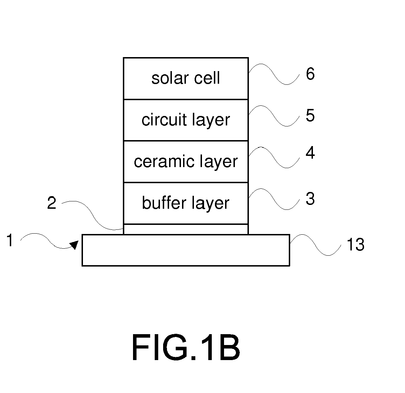

Please refer to FIG.1A and FIG.1B, which are sectional views showing a first and a second preferred embodiments according to the present invention. As shown in the figures, the present invention is a solar cell dissipation package, comprising a dissipation unit 1, a mount layer 2, a buffer layer 3, a ceramic layer 4, a circuit layer 5 and a solar cell 6, where the ceramic layer 4 is firmly bound to the dissipation unit 1 with the buffer layer 3 and the mount layer 2 in between for improving dissipation efficiency.

The dissipation unit 1 has a flat surface 11 and the flat surface 11 is extended with fins 12, where the dissipation unit 1 is made of copper or a mixture of aluminum and nickel. Or, the dissipation unit 1 is a flat metal plate 13.

The mount layer 2 is mounted on the flat surface 11 of the dissipation unit 1 and is made of solder paste.

The buffer layer 3 is mounted on a surface of the mount layer 2 and is made of solder paste.

The ceramic layer 4 is mounted on a surface of the buffer layer 3.

The circuit layer 5 is mounted on a surface of the ceramic layer 4; and the circuit layer 5 has an electric circuit layout to be coordinated with the solar cell 6.

The solar cell 6 is mounted on a surface of the circuit layer 5. Thus, a novel solar cell dissipation package is obtained.

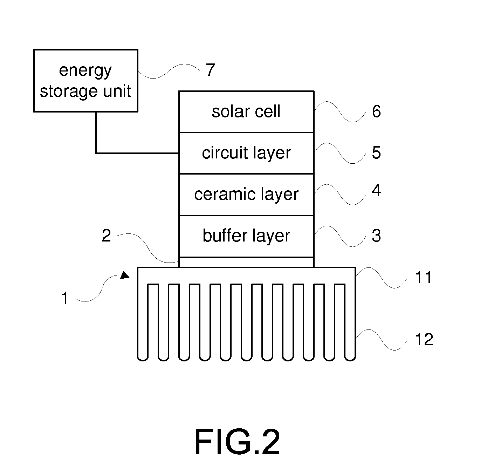

Please refer to FIG.2, which is a sectional view showing a state of use. As shown in the figure, on using the present invention, a circuit layer 5 is connected with an energy storage unit 7. Sun light is absorbed by a solar cell 6 for a photo-electric conversion. Then electricity obtained from the solar cell 6 after the conversion is transferred through a circuit layer 5 and is stored in the energy storage unit 7. When the solar cell 6 absorbs the sun light and the circuit layer 5 is functioned, a heat is generated. The heat is at first absorbed by a ceramic layer 4; then is transferred to a dissipation unit 1 through a buffer layer 3 and a mount layer 2. Then, the heat is dissipated by the dissipation unit 1 through fins 12. Hence, a better heat dissipation efficiency is obtained for the solar cell 6 and the circuit layer 5. And, thus, the solar cell 6 and the circuit layer 5 have better functionality and stability.

To sum up, the present invention is a solar cell dissipation package, where a ceramic layer is firmly bound to a dissipation unit with a buffer layer and a mount layer in between for improving dissipation efficiency.

The preferred embodiments herein disclosed are not intended to unnecessarily limit the scope of the invention. Therefore, simple modifications or variations belonging to the equivalent of the scope of the claims and the instructions disclosed herein for a patent are all within the scope of the present invention.

## Claims

1. A solar cell dissipation package, comprising:
a dissipation unit (1), said dissipation unit having a flat surface (11), said flat surface (11) being extended with fins (12);
a mount layer (2), said mount layer being deposed on said flat surface (11) of said dissipation unit (1);
a buffer layer (3), said buffer layer (3) being deposed on a surface of said mount layer (2);
a ceramic layer (4), said ceramic layer (4) being deposed on a surface of said buffer layer (3);
a circuit layer (5), said circuit layer (5) being deposed on a surface of said ceramic layer (4); and
a solar cell (6), said solar cell (6) being deposed on a surface of said circuit layer (5).

2. The package according to claim 1,
wherein said dissipation unit 1 is a flat metal plate 13.

3. The package according to claim 1,
wherein said dissipation unit 1 is made of copper.

4. The package according to claim 1,
wherein said dissipation unit 1 is made of a mixture of aluminum and nickel.

5. The package according to claim 1,
wherein said mount layer 2 is made of a solder paste.

6. The package according to claim 1,
wherein said buffer layer 3 is made of a solder paste.

7. The package according to claim 1,
wherein said circuit layer 5 is connected with an energy storage unit 7.
